# EUROPEAN PATENT SPECIFICATION

(11) **EP 4 454 410 B1**
(45) Date of publication and mention of the grant of the patent: **17.12.2025**
(21) Application number: 22836291.9
(22) Date of filing: 21.12.2022
(51) Int. Cl.: H05B 6/10, A24F 40/465

(54) **AN INDUCTION HEATING ASSEMBLY FOR AN AEROSOL GENERATING DEVICE**
INDUKTIONSHEIZUNGSANORDNUNG FÜR EINE AEROSOLERZEUGUNGSVORRICHTUNG
ENSEMBLE DE CHAUFFAGE PAR INDUCTION POUR UN DISPOSITIF DE GÉNÉRATION D'AÉROSOL

(30) Priority: 22.12.2021 EP 21217171
(43) Date of publication of application: 30.10.2024
(73) Proprietor: JT International SA, 1202 Geneva (CH)
(72) Inventor: GARCIA GARCIA, Eduardo Jose, 1218 Grand-Saconnex (CH)
(74) Representative: Serjeants LLP
(86) International application number: PCT/EP2022/087196
(87) International publication number: WO 2023/118272

(56) References cited:
- EP-A1- 3 918 931
- WO-A1-2019/129639
- US-A1- 2017 079 326
- US-A1- 2020 404 968

## Description

### Technical Field

The present disclosure relates generally to an induction heating assembly for an aerosol generating device, and more particularly to an induction heating assembly for an aerosol generating device for heating an aerosol generating substrate to generate an aerosol for inhalation by a user. Embodiments of the present disclosure also relate to an aerosol generating device.

### Technical Background

Devices which heat, rather than bum, an aerosol generating substrate to produce an aerosol for inhalation have become popular with consumers in recent years.

Such devices can use one of a number of different approaches to provide heat to the substrate. One such approach is to provide an aerosol generating device which employs an induction heating system including an inductor.

Electrical energy is provided to the inductor when a user activates the device which in turn generates an alternating electromagnetic field. A susceptor couples with the electromagnetic field and generates heat, which is transferred, for example by conduction, to the substrate and an aerosol is generated as the substrate is heated for inhalation by a user of the device.

A shortcoming of the use of an induction heating system is that leakage of the electromagnetic field may occur. Furthermore, heat generated may cause the housing of the device to become hot. There is, therefore, a need to address these shortcomings.

International patent publication WO2019/129639 describes an induction heating assembly for a vapour generating device that comprises an induction coil and a heating compartment arranged to receive an induction heatable cartridge. A first electromagnetic shield layer is arranged outward of the induction coil and a second electromagnetic shield layer is arranged outward of the first electromagnetic shield layer. The first and second electromagnetic shield layers differ in one or both of their electrical conductivity and their magnetic permeability.

### Summary of the Disclosure

According to a first aspect of the present disclosure, there is provided an induction heating assembly for an aerosol generating device as set out in claim 1.

The structure reduces leakage of the electromagnetic field generated by the induction coil, i.e., provides a shielding effect. Furthermore, the structure improves thermal insulation ensuring that the housing of the aerosol generating device does not become hot so that a user can handle the device without any discomfort. Thermal insulation is the reduction of heat transfer (the transfer of thermal energy between objects of differing temperature) between objects in thermal contact.

The heating assembly may further comprise an induction heatable susceptor arranged around the periphery of the tubular heating compartment, i.e. a tubular induction heatable susceptor. In this way the induction heatable susceptor may be shaped to surround an aerosol generating substrate during use. The tubular induction heatable susceptor may be external to the heating compartment, or may be provided as a wall of the heating compartment. The tubular induction heatable susceptor may be internal to the heating compartment. For example, the tubular induction heatable susceptor may be provided in an aerosol generating article intended received within the tubular heating compartment, with the tubular induction heatable susceptor surrounding an aerosol generating substrate comprised within the aerosol generating article.

The structure may comprise a second thermally insulating layer arranged inward of the first electromagnetic shield layer. Such an arrangement ensures that an optimal alternating electromagnetic field is generated by the induction coil and further improves thermal insulation.

Possibly, the second thermally insulating layer has an outer surface that contacts an inner surface of the first electromagnetic shield layer.

The first thermally insulating layer may comprise one or more sheets of thermally insulating material. The first thermally insulating layer may comprise air pockets. Air pockets further improve thermal insulation. The first thermally insulating layer may comprise ceramic fibre, one or more metal oxides, or an aerogel such as Finesulight^{™}. The ceramic fibre may comprise aluminium oxide, silicon oxide and/or ZrO₂.

The second thermally insulating layer may comprise one or more sheets of thermally insulating material. The second thermally insulating layer may comprise air pockets. Air pockets further improve thermal insulation. The second thermally insulating layer may comprise ceramic fibre, one or more metal oxides, or an aerogel such as Finesulight^{™}. The ceramic fibre may comprise aluminium oxide, silicon oxide and/or ZrO₂. The second thermally insulating layer may comprise a different material to the first thermally insulating layer.

The first and second electromagnetic shield layers may differ in one of or both of their electrical conductivity and their magnetic permeability.

Possibly, one of the first or second electromagnetic shield layers comprises a ferrimagnetic, non- electrically conductive material; and the other the first or second electromagnetic shield layers comprises an electrically conductive material. Possibly, the first electromagnetic shield layer comprises a ferrimagnetic, non-electrically conductive material; and the second electromagnetic shield layer comprises an electrically conductive material. Possibly, the ferrimagnetic, non-electrically conductive material comprises ferrite, nickel zinc ferrite or mu-metal; and wherein the electrically conductive material comprises aluminium, graphite or copper.

The second electromagnetic shield layer may comprise a mesh.

The first and second electromagnetic shield layers may be substantially uniformly spaced apart by a distance of from 0.5 mm to 1.5 mm. This degree of separation improves the shielding effect of the respective first and second electromagnetic shield layers.

The structure may comprise a third thermally insulating layer arranged outward of the first thermally insulating layer. The third thermally insulating layer may comprise a different material to the first thermally insulating layer (and/or to the second thermally insulating layer, if present). Such an arrangement may improve thermal insulation by spreading heat which escapes through the first thermally insulating layer.

The third thermally insulating layer may comprise graphite. The third thermally insulating layer may be provided in place of the second electromagnetic shield layer, or inward of the second electromagnetic shield layer. Thus, the third thermally insulating layer may comprise an inner surface that contacts the outer surface of the first thermally insulating layer. The third thermally insulating layer may be provided in addition to or instead of the second thermally insulating layer.

The structure may comprise one or more further electromagnetic shield layers and/or one or more further thermally insulating layers. The structure can thus be configured for different applications. Possibly, the structure is configured such that a thermally insulating layer is disposed between any two adjacent electromagnetic shield layers. Possibly, the structure is configured such that none of the electromagnetic shield layers contact one another.

The structure may substantially surround the heating compartment. The shielding effect and thermal insulation are thus maximised.

The structure may extend around the circumference of the tubular heating compartment and extend over the majority, and preferably the entirety, of the length of the heating compartment. The shielding effect and thermal insulation are thus maximised.

According to a second aspect of the present disclosure, there is provided an aerosol generating device comprising an induction heating assembly as set out in claim 15.

Also described is an induction heating assembly for an aerosol generating device, the induction heating assembly comprising:
a tubular heating compartment arranged to receive an aerosol generating substrate;
a helical induction coil surrounding the tubular heating compartment; and
a structure arranged around the helical induction coil, wherein the structure comprises:
   a first electromagnetic shield layer;
   a first thermally insulating layer arranged outward of the first electromagnetic shield layer;
   a third thermally insulating layer arranged outward of the first thermally insulating layer;
wherein the first thermally insulating layer has an inner surface that contacts an outer surface of the first electromagnetic shield layer and an outer surface that contacts an inner surface of the third thermally layer. The induction heating assembly may include any of the optional features discussed above in connection with the first aspect of the disclosure.

### Brief Description of the Drawings

Figure 1 is a diagrammatic cross-sectional view of an aerosol generating device comprising an induction heating assembly;
Figure 2 is a diagrammatic part cross-sectional view of the aerosol generating device of Figure 1 with an aerosol generating substrate received in a heating compartment of the induction heating assembly;
Figure 3a is a diagrammatic cross-sectional detailed view of the circled portion of the aerosol generating device of Figure 2; and
Figure 3b is a diagrammatic cross-sectional detailed view of the circled portion of the aerosol generating device of Figure 2, but with the layers shown spaced apart purely for illustration purposes.

### Detailed Description of Embodiments

Embodiments of the present disclosure will now be described by way of example only and with reference to the accompanying drawings.

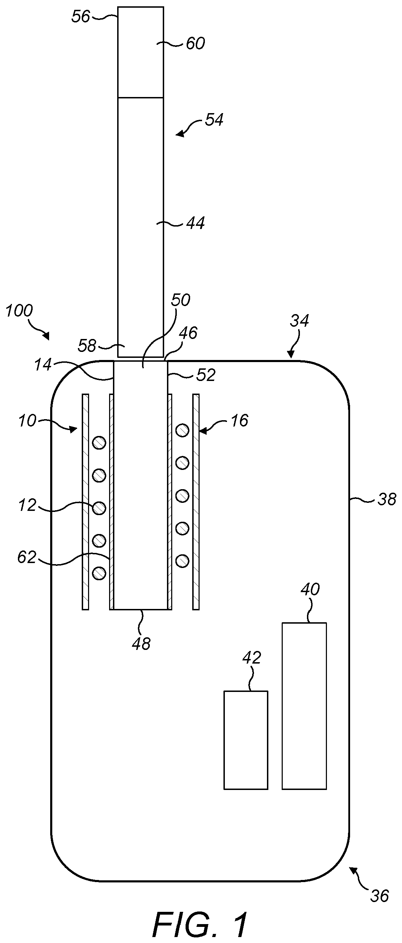

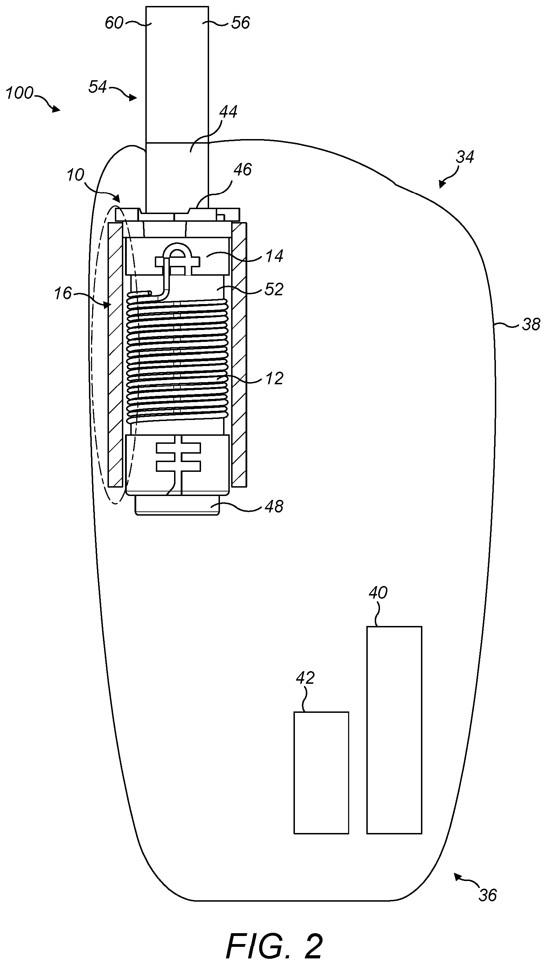

Referring initially to Figures 1 and 2, there is shown diagrammatically an example of an aerosol generating device 100 according to the present disclosure. The aerosol generating device 100 may equally be referred to as a "heated tobacco device", a "heat-not-burn tobacco device", a "device for vaporising tobacco products", and the like, with this being interpreted as a device suitable for achieving these effects. The features disclosed herein are equally applicable to devices which are designed to vaporise any aerosol generating substrate.

The aerosol generating device 100 is a hand-held, portable, device, by which it is meant that a user is able to hold and support the device unaided, in a single hand. The aerosol generating device 100 has a first (or proximal) end 34 and a second (or distal) end 36 and comprises a device housing 38.

In the illustrated example, the aerosol generating device 100 includes a controller 40. The aerosol generating device 100 may include a user interface for controlling the operation of the aerosol generating device 100 via the controller 40.

The controller 40 is configured to detect the initiation of use of the aerosol generating device 100 in response to a user input, such as a button press to activate the aerosol generating device 100, or in response to a detected airflow through the aerosol generating device 100. As will be understood by one of ordinary skill in the art, an airflow through the aerosol generating device 100 is indicative of a user inhalation or 'puff'. The aerosol generating device 100 may, for example, include a puff detector, such as an airflow sensor (not shown), to detect an airflow through the aerosol generating device 100.

The controller 40 includes electronic circuitry. The aerosol generating device 100 includes a power source 42, such as a battery. The power source 42 and the electronic circuitry may be configured to operate at a high frequency. The power source 42 and the electronic circuitry may be configured to operate at a frequency of between approximately 80 kHz and 500 kHz, possibly between approximately 150 kHz and 250 kHz, and possibly at approximately 200 kHz. The power source 42 and the electronic circuitry could be configured to operate at a higher frequency, for example in the MHz range, if required.

The aerosol generating device 100 comprises an induction heating assembly 10. The induction heating assembly 10 comprises a heating compartment 14. The heating compartment 14 is arranged to receive an aerosol generating substrate 44. In some examples, the heating compartment 14 has a substantially cylindrical cross-section. The heating compartment 14 defines a cavity.

The heating compartment 14 has a first end 46 and a second end 48. The heating compartment 14 includes an opening 50 at the first end 46 for receiving an aerosol generating substrate 44. In the illustrated example, the heating compartment 14 includes a substantially cylindrical side wall 52, i.e., a side wall 52 which has a substantially circular cross-section.

The aerosol generating substrate 44 may be any type of solid or semi-solid material. Example types of aerosol generating solids include powder, granules, pellets, shreds, strands, particles, gel, strips, loose leaves, cut leaves, cut filler, porous material, foam material or sheets. The aerosol generating substrate 44 may comprise plant derived material and in particular, may comprise tobacco. It may advantageously comprise reconstituted tobacco.

The aerosol generating substrate 44 may comprise an aerosol-former. Examples of aerosol-formers include polyhydric alcohols and mixtures thereof such as glycerine or propylene glycol. Typically, the aerosol generating substrate may comprise an aerosol-former content of between approximately 5% and approximately 50% on a dry weight basis. In some example, the aerosol generating substrate 44 may comprise an aerosol-former content of between approximately 10% and approximately 20% on a dry weight basis, and possibly approximately 15% on a dry weight basis.

Upon heating, the aerosol generating substrate 44 may release volatile compounds. The volatile compounds may include nicotine or flavour compounds such as tobacco flavouring.

In the illustrated example, the aerosol generating substrate 44 is comprised in an aerosol generating article 54. The shape of the aerosol generating article 54 corresponds to the shape of the heating compartment 14. The aerosol generating article 54 may be generally cylindrical or rod-shaped. The aerosol generating article may be formed substantially in the shape of a stick, and may broadly resemble a cigarette, having a tubular region with an aerosol generating substrate 44 arranged in a suitable manner. The aerosol generating article 54 is a disposable and replaceable article which may, for example, contain tobacco as the aerosol generating substrate 44. The aerosol generating article 54 has a first end 56 (or mouth end), a second end 58, and comprises a filter 60 at the first end 56. The filter 60 acts as a mouthpiece and may comprise an air-permeable plug, for example comprising cellulose acetate fibres.

The aerosol generating substrate 44 and filter 60 may be circumscribed by a paper wrapper and may, thus, be embodied as an aerosol generating article 54. One or more vapour collection regions, cooling regions, and other structure may also be included in some designs.

To use the aerosol generating device 100, a user inserts an aerosol generating article 54 through the opening 50 into the heating compartment 14, so that the second end 58 of the aerosol generating article 54 is positioned at the second end 48 of the heating compartment 14 and so that the filter 60 at the first end 56 of the aerosol generating article 54 projects from the first end 46 of the heating compartment 14 to permit engagement by a user's lips.

The induction heating assembly 10 further comprises an induction coil 12. The induction coil 12 is arranged to be energised to generate an alternating electromagnetic field for inductively heating an induction heatable susceptor 62. The induction heatable susceptor 62 may be arranged around the periphery of the heating compartment 14 as illustrated, or alternatively may be arranged to project into the heating compartment 14 from the second end 48 (e.g., as a heating blade or pin) to penetrate the aerosol generating substrate 44) or may be provided in the aerosol generating substrate 44 during manufacture of the aerosol generating article 54. The induction heatable susceptor 62 may be tubular and surrounding the aerosol generating substrate 44.

In use, heat from the induction heatable susceptor 62 is transferred to the aerosol generating substrate 44 of an aerosol generating article 54 positioned in the heating compartment 14, for example by conduction, radiation and convection, to heat the aerosol generating substrate 44 (without burning the aerosol generating substrate 44) and thereby generate a vapour which cools and condenses to form an aerosol for inhalation by a user of the aerosol generating device 100, for instance, through the filter 60. The vaporisation of the aerosol generating substrate 44 is facilitated by the addition of air from the surrounding environment, e.g., through an air inlet (not shown).

In general terms, a vapour is a substance in the gas phase at a temperature lower than its critical temperature, which means that the vapour can be condensed to a liquid by increasing its pressure without reducing the temperature, whereas an aerosol is a suspension of fine solid particles or liquid droplets, in air or another gas. It should, however, be noted that the terms 'aerosol' and 'vapour' may be used interchangeably in this specification, particularly with regard to the form of the inhalable medium that is generated for inhalation by a user.

The induction coil 12 can be energised by the power source 42 and controller 40. The induction coil 12 may comprise a Litz wire or a Litz cable. It will, however, be understood that other materials could be used. In the illustrated example, the induction coil 12 extends around the heating compartment 14.

In the illustrated example, the induction coil 12 extends around the heating compartment 14. Accordingly, the induction coil 12 is annular. In the illustrated example, the induction coil 12 is substantially helical in shape. In some examples, the circular cross-section of a helical induction coil 12 may facilitate the insertion of an aerosol generating substrate 44, or for example an aerosol generating article 54 including the aerosol generating substrate 44 and optionally one or more induction heatable susceptors 62, into the heating compartment 14 and ensure uniform heating of the aerosol generating substrate 44.

In the illustrated example, the induction heatable susceptor 62 comprises an electrically conductive material. The induction heatable susceptor 62 may comprise one or more, but not limited to, of graphite, molybdenum, silicon carbide, niobium, aluminium, iron, nickel, nickel containing compounds, titanium, mild steel, stainless steel, low carbon steel and alloys thereof, e.g., nickel chromium or nickel copper, and composites of metallic materials. In some examples, the induction heatable susceptor 62 comprises a metal selected from the group consisting of mild steel, stainless steel and low carbon stainless steel.

In use, with the application of an electromagnetic field in its vicinity, the susceptor(s) 62 generate heat due to eddy currents and magnetic hysteresis losses resulting in a conversion of energy from electromagnetic to heat.

The induction coil 12 may be arranged to operate in use with a fluctuating electromagnetic field having a magnetic flux density of between approximately 20mT and approximately 2.0T at the point of highest concentration.

The induction heating assembly 10 further comprises a structure 16 arranged around the induction coil 12. Accordingly, the structure 16 is arranged outward of the induction coil 12. In the illustrated example, the structure 16 substantially surrounds the induction coil 12.

In the illustrated example, the structure 16 substantially surrounds the heating compartment 14. The heating compartment 14 is tubular. Thus the susceptor 62 arranged around the periphery of the heating compartment 14 is also tubular. In the illustrated example, the structure 16 extends around the circumference of the tubular heating compartment 14 and extends over the majority, and preferably the entirety, of the length of the heating compartment 14. The shielding effect and thermal insulation are thus maximised.

**In** the illustrated example, the structure 16 is substantially cylindrical, for example in the form of a substantially cylindrical sleeve, which is positioned radially outwardly of the induction coil 12 so as to extend circumferentially around the induction coil 12. Accordingly, in the illustrated example the structure 16 is arranged circumferentially around the induction coil 12.

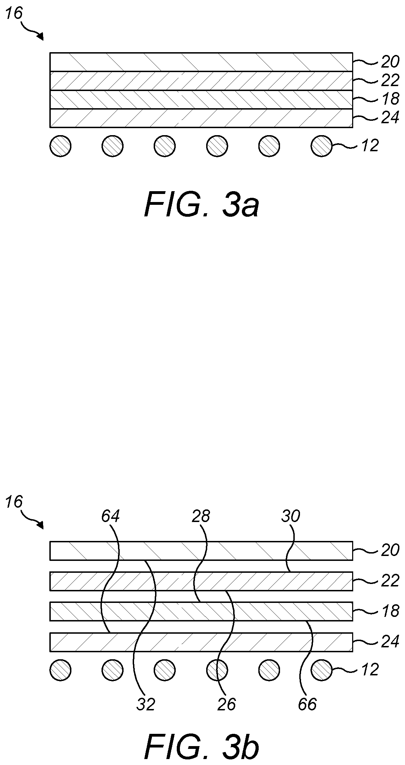

Figures 3a and 3b show a detailed view of the structure 16. **In** the illustrated example, the structure 16 comprises an arrangement of layers. **In** Figure 3b, the layers are shown spaced apart purely for illustration purposes. Referring to Figures 3a and 3b, the structure 16 comprises a first electromagnetic shield layer 18 and a second electromagnetic shield layer 20. The second electromagnetic shield layer 20 is arranged outward of the first electromagnetic shield layer 18. The first and second electromagnetic shield layers 18, 20 may differ in one of or both of their electrical conductivity and their magnetic permeability.

The first electromagnetic shield layer 18 is typically formed of a ferrimagnetic, non-electrically conductive material such as ferrite, Nickel Zinc Ferrite or mu-metal.

The first electromagnetic shield layer 18 may comprise a laminate structure and may, thus, itself comprise a plurality of layers. The layers may comprise the same material or may comprise a plurality of different materials, for example which are selected to provide the desired shielding properties. The first electromagnetic shield layer 18 could, for example, comprise one or more layers of ferrite and one or more layers of an adhesive material.

The first electromagnetic shield layer 18 may have a thickness between 0.1 mm and 10 mm. **In** some examples, the thickness may be between 0.1 mm and 6 mm, more preferably the thickness may be between 0.7 mm and 2.0 mm.

The second electromagnetic shield layer 20 typically comprises an electrically conductive material, for example a metal such as aluminium or copper, and may be in the form of a mesh.

The second electromagnetic shield layer 20 may comprise a laminate structure and may, thus, itself comprise a plurality of layers. The layers may comprise the same material or may comprise a plurality of different materials, for example which are selected to provide the desired shielding properties.

The second electromagnetic shield layer 20 may have a thickness between 0.1 mm and 0.5 mm. In some examples, the thickness may be between 0.1 mm and 0.2 mm.

The resistance value of the second electromagnetic shield layer 20 is selected to minimise heating and conductive losses in the second electromagnetic shield layer 20. The resistance value of the second electromagnetic shield layer 20 may for example be less than 30 mΩ. In some example, the resistance value may be less than 15 mΩ and may be less than 10 mΩ.

The structure 16 further comprises a first thermally insulating layer 22 disposed between the first and second electromagnetic shield layers 18, 20. The first thermally insulating layer 22 has an inner surface 26 that contacts an outer surface 28 of the first electromagnetic shield layer 18. The first thermally insulating layer 22 has an outer surface 30 that contacts an inner surface 32 of the second electromagnetic shield layer 20. The first thermally insulating layer 22 may be wrapped in between the first and second electromagnetic shield layers 18, 20.

In the illustrated example, the first and second electromagnetic shield layers 18, 20 are substantially uniformly spaced apart. The first and second electromagnetic shield layers 18, 20 are substantially uniformly spaced apart by the first thermally insulating layer 22. The distance separating the first and second electromagnetic shield layers 18, 20 may be from 0.5 mm to 1.5 mm. This degree of separation improves the shielding effect of the respective first and second electromagnetic shield layers 18, 20. This distance corresponds to the thickness of the first thermally insulating layer 22. Accordingly, the first thermally insulating layer 22 has a uniform thickness of from 0.5 mm to 1.5 mm.

In the illustrated example, the structure 16 further comprises a second thermally insulating layer 24. The second thermally insulating layer 24 is arranged inward of the first electromagnetic shield layer 18. The structure 16 is arranged such that the second thermally insulating layer 24 is adjacent to the induction coil 12. Such an arrangement ensures that an optimal alternating electromagnetic field is generated by the induction coil 12.

In the illustrated example, the second thermally insulating layer 24 has an outer surface 64 that contacts an inner surface 66 of the first electromagnetic shield layer 18. Accordingly, the second thermally insulating layer 24 contacts the first electromagnetic shield layer 18. The first electromagnetic shield layer 18 also contacts the first thermally insulating layer 22. The first thermally insulating layer 22 also contacts the second electromagnetic shield layer 20.

The first and/or second thermally insulating layers 22, 24 may, for example, comprise a laminate structure or a composite structure and may, thus, respectively comprise a plurality of layers and/or a mixture of particles/elements. The layers or mixture of particles/elements may comprise the same material or may comprise a plurality of different materials

The first and second thermally insulating layers 22, 24 may comprise one or more sheets of thermally insulating material. The first and second thermally insulating layers 22, 24 may comprise Superwool^{™}, which is a ceramic fibre. The ceramic fibre may comprise aluminium oxide, silicon oxide and/or ZrO₂. In other examples, the first and/or second thermally insulating layers 22, 24 may alternatively or additionally comprise one or more metal oxides, or an aerogel. The first and second thermally insulating layers 22, 24 may comprise Finesulight^{™}, which is a type of aerogel.

The first and/or second thermally insulating layers 22, 24 may comprise air pockets. Air pockets are internal structures comprised in the material of the first and/or second thermally insulating layers 22, 24. For instance, in the case of Superwool^{™}, the internal structures are defined between the ceramic fibres. The air pockets retain air which contributes to, and thus improves, thermal insulation.

In some examples, a third thermally insulating layer may be provided inward of the second electromagnetic shielding layer, or instead of the second electromagnetic shielding layer. The third thermally insulating may comprise a material such as graphite, which is effective at heat spreading The reference to a third thermally insulating layer does not necessarily imply the presence of a second thermally insulating layer. That is, some examples may provide a layered structure comprising a first electromagnetic shield layer, a first thermally insulating layer, and a third thermally insulating layer. The first electromagnetic shield layer may be wrapped by the first thermally insulating layer, which may be wrapped by the third thermally insulating layer. An example of such a three layer structure could comprise ferrite (for shielding), Finesulight^{™} (for thermal insulation) and graphite (for hot spot reduction).

**In** some examples, the structure 16 may comprise one or more further electromagnetic shield layers 18, 20 and/or one or more further thermally insulating layers 22, 24. The structure 16 can thus be configured for different applications. **In** such examples, the structure 16 is configured such that a thermally insulating layer is disposed between any two adjacent electromagnetic shield layers. The structure 16 is configured such that none of the electromagnetic shield layers contact one another.

The structure 16 comprises multiple layers and is therefore a laminate structure.

A structure 16 with an arrangement disclosed above reduces leakage of the electromagnetic field generated by the induction coil 12. Furthermore, such a structure 16 improves thermal insulation ensuring that the housing 38 (i.e., casing) of the aerosol generating device 100 does not become hot so that a user can handle the aerosol generating device 100 without any discomfort. Thermal insulation is the reduction of heat transfer (the transfer of thermal energy between objects of differing temperature) between objects in thermal contact.

Although exemplary embodiments have been described in the preceding paragraphs, it should be understood that various modifications may be made to those embodiments without departing from the scope of the appended claims. Thus, the breadth and scope of the claims should not be limited to the above-described exemplary embodiments.

Unless the context clearly requires otherwise, throughout the description and the claims, the words "comprise", "comprising", and the like, are to be construed in an inclusive as opposed to an exclusive or exhaustive sense; that is to say, in the sense of "including, but not limited to".

## Claims

1. An induction heating assembly (10) for an aerosol generating device (100), the induction heating assembly (10) comprising:
a tubular heating compartment (14) arranged to receive an aerosol generating substrate;
a helical induction coil (12) surrounding the tubular heating compartment; and
a structure (16) arranged around the helical induction coil (12), wherein the structure (16) comprises:
a first electromagnetic shield layer (18); and
a second electromagnetic shield layer (20) arranged outward of the first electromagnetic shield layer (18);
**characterised in that** the structure further comprises:
a first thermally insulating layer (22) disposed between the first and second electromagnetic shield layers (18, 20);
wherein the first thermally insulating layer (22) has an inner surface (26) that contacts an outer surface (28) of the first electromagnetic shield layer (18) and an outer surface (30) that contacts an inner surface (32) of the second electromagnetic shield layer (20).

2. An induction heating assembly according to claim 1, wherein the heating assembly further comprises an induction heatable susceptor arranged around the periphery of the tubular heating compartment.

3. An induction heating assembly according to claim 1 or claim 2, wherein the structure (16) comprises a second thermally insulating layer (24) arranged inward of the first electromagnetic shield layer (18).

4. An induction heating assembly according to any preceding claim, wherein the first thermally insulating layer (22) comprises one or more sheets of thermally insulating material.

5. An induction heating assembly according to any preceding claim, wherein the first thermally insulating layer (22) comprises air pockets.

6. An induction heating assembly according to any of the preceding claims, wherein the first thermally insulating layer (22) comprises ceramic fibre, one or more metal oxides, or an aerogel, wherein the ceramic fibre optionally comprises aluminium oxide, silicon oxide and/or ZrO₂.

7. An induction heating assembly according to any of the preceding claims, wherein the first and second electromagnetic shield layers (18, 20) differ in one of or both of their electrical conductivity and their magnetic permeability.

8. An induction heating assembly according to any of the preceding claims, wherein one of the first or second electromagnetic shield layers (18, 20) comprises a ferrimagnetic, non-electrically conductive material; and the other the first or second electromagnetic shield layers (18, 20) comprises an electrically conductive material.

9. An induction heating assembly according to any of the preceding claims, wherein the first electromagnetic shield layer (18) comprises a ferrimagnetic, non-electrically conductive material; and the second electromagnetic shield layer (20) comprises an electrically conductive material.

10. An induction heating assembly according to claims 8 or 9, wherein the ferrimagnetic, non-electrically conductive material comprises ferrite, nickel zinc ferrite or mu-metal; and wherein the electrically conductive material comprises aluminium, graphite or copper.

11. An induction heating assembly according to any of the preceding claims, wherein the second electromagnetic shield layer (20) comprises a mesh.

12. An induction heating assembly according to any of the preceding claims, wherein the first and second electromagnetic shield layers (18, 20) are substantially uniformly spaced apart by a distance of from 0.5 mm to 1.5 mm.

13. An induction heating assembly according to any of the preceding claims, wherein the structure (16) substantially surrounds the tubular heating compartment (14).

14. An induction heating assembly according to any of the preceding claims, wherein the structure (16) comprises one or more further electromagnetic shield layers (18, 20) and/or one or more further thermally insulating layers (22, 24).

15. An aerosol generating device (100) comprising an induction heating assembly (10) according to any of the preceding claims.

## Patentansprüche

1. Induktionsheizungsanordnung (10) für eine Aerosolerzeugungsvorrichtung (100), die Induktionsheizvorrichtung (10) umfassend:
einen rohrförmigen Heizbereich (14), der zur Aufnahme eines Aerosolerzeugungssubstrats angeordnet ist;
eine helixförmige Induktionsspule (12), die den rohrförmigen Heizbereich umgibt; und
eine um die helixförmige Induktionsspule (12) herum angeordnete Struktur (16), wobei die Struktur (16) Folgendes umfasst:
eine erste elektromagnetische Abschirmschicht (18); und
eine zweite elektromagnetische Abschirmschicht (20), die außenseitig der ersten elektromagnetischen Abschirmschicht (18) angeordnet ist;
**dadurch gekennzeichnet, dass** die Struktur weiter umfasst:
eine erste wärmeisolierende Schicht (22), die sich zwischen der ersten und der zweiten elektromagnetischen Abschirmschicht (18, 20) befindet;
wobei die erste wärmeisolierende Schicht (22) eine Innenfläche (26) aufweist, die eine Außenfläche (28) der ersten elektromagnetischen Abschirmschicht (18) berührt, und eine Außenfläche (30), die eine Innenfläche (32) der zweiten elektromagnetischen Abschirmschicht (20) berührt.

2. Induktionsheizungsanordnung nach Anspruch 1, wobei die Heizungsanordnung weiter einen mittels Induktion erwärmbaren Suszeptor umfasst, der am Umfang des rohrförmigen Heizbereichs angeordnet ist.

3. Induktionsheizungsanordnung nach Anspruch 1 oder Anspruch 2, wobei die Struktur (16) eine zweite wärmeisolierende Schicht (24) umfasst, die innenseitig der ersten elektromagnetischen Abschirmschicht (18) angeordnet ist.

4. Induktionsheizungsanordnung nach einem vorstehenden Anspruch, wobei die erste wärmeisolierende Schicht (22) eine oder mehrere Lagen eines wärmeisolierenden Materials umfasst.

5. Induktionsheizungsanordnung nach einem vorstehenden Anspruch, wobei die erste wärmeisolierende Schicht (22) Lufteinschlüsse umfasst.

6. Induktionsheizungsanordnung nach einem der vorstehenden Ansprüche, wobei die erste wärmeisolierende Schicht (22) Keramikfaser, ein oder mehrere Metalloxide oder ein Aerogel umfasst, wobei die Keramikfaser optional Aluminiumoxid, Siliciumoxid und/oder ZrO₂ umfasst.

7. Induktionsheizungsanordnung nach einem der vorstehenden Ansprüche, wobei sich die erste und die zweite elektromagnetische Abschirmschicht (18, 20) in ihrer elektrischen Leitfähigkeit und/oder in ihrer magnetischen Permeabilität unterscheiden.

8. Induktionsheizungsanordnung nach einem der vorstehenden Ansprüche, wobei eine der ersten oder zweiten elektromagnetischen Abschirmschichten (18, 20) ein ferrimagnetisches, nicht elektrisch leitendes Material umfasst; und die andere der ersten oder zweiten elektromagnetischen Abschirmschichten (18, 20) ein elektrisch leitendes Material umfasst.

9. Induktionsheizungsanordnung nach einem der vorstehenden Ansprüche, wobei die erste elektromagnetische Abschirmschicht (18) ein ferrimagnetisches, nicht elektrisch leitendes Material umfasst; und die zweite elektromagnetische Abschirmschicht (20) ein elektrisch leitendes Material umfasst.

10. Induktionsheizungsanordnung nach den Ansprüchen 8 oder 9, wobei das ferrimagnetische, nicht elektrisch leitende Material Ferrit, Nickel-Zink-Ferrit oder Mumetall umfasst; und wobei das elektrisch leitende Material Aluminium, Graphit oder Kupfer umfasst.

11. Induktionsheizungsanordnung nach einem der vorstehenden Ansprüche, wobei die zweite elektromagnetische Abschirmschicht (20) ein Gitter umfasst.

12. Induktionsheizungsanordnung nach einem der vorstehenden Ansprüche, wobei die erste und die zweite elektromagnetische Abschirmschicht (18, 20) im Wesentlichen gleichmäßig in einem Abstand von 0,5 mm bis 1,5 mm beabstandet sind.

13. Induktionsheizungsanordnung nach einem der vorstehenden Ansprüche, wobei die Struktur (16) den rohrförmigen Heizbereich (14) im Wesentlichen umgibt.

14. Induktionsheizungsanordnung nach einem der vorstehenden Ansprüche, wobei die Struktur (16) eine oder mehrere weitere elektromagnetische Abschirmschichten (18, 20) und/oder eine oder mehrere weitere wärmeisolierende Schichten (22, 24) umfasst.

15. Aerosolerzeugungsvorrichtung (100), umfassend eine Induktionsheizungsanordnung (10) nach einem der vorstehenden Ansprüche.

## Revendications

1. Ensemble (10) de chauffage par induction pour un dispositif (100) de génération d'aérosol, l'ensemble (10) de chauffage par induction comprenant :
un compartiment tubulaire (14) de chauffage, conçu pour recevoir un substrat générateur d'aérosol ;
une bobine hélicoïdale d'induction (12), entourant le compartiment tubulaire de chauffage ; et
une structure (16) agencée autour de la bobine hélicoïdale d'induction (12), dans laquelle la structure (16) comprend :
une première couche de blindage électromagnétique (18) ; et
une seconde couche de blindage électromagnétique (20) agencée à
l'extérieur de la première couche de blindage électromagnétique (18) ;
**caractérisé en ce que** la structure comprend en outre :
une première couche d'isolation thermique (22) disposée entre les première et seconde couches de blindage électromagnétique (18, 20) ;
dans laquelle la première couche d'isolation thermique (22) présente une surface interne (26) qui est en contact avec une surface externe (28) de la première couche de blindage électromagnétique (18) et une surface externe (30) qui est en contact avec une surface interne (32) de la seconde couche de blindage électromagnétique (20).

2. Ensemble de chauffage par induction selon la revendication 1, dans lequel l'ensemble de chauffage comprend en outre un suscepteur chauffable par induction, agencé autour du pourtour du compartiment tubulaire de chauffage.

3. Ensemble de chauffage par induction selon la revendication 1 ou la revendication 2, dans lequel la structure (16) comprend une seconde couche d'isolation thermique (24) disposée à l'intérieur de la première couche de blindage électromagnétique (18).

4. Ensemble de chauffage par induction selon l'une quelconque des revendications précédentes, dans lequel la première couche d'isolation thermique (22) comprend une ou plusieurs feuilles de matériau d'isolation thermique.

5. Ensemble de chauffage par induction selon l'une quelconque des revendications précédentes, dans lequel la première couche d'isolation thermique (22) comprend des poches d'air.

6. Ensemble de chauffage par induction selon l'une quelconque des revendications précédentes, dans lequel la première couche d'isolation thermique (22) comprend de la fibre céramique, un ou plusieurs oxydes métalliques, ou un aérogel, la fibre céramique comprenant facultativement de l'oxyde d'aluminium, de l'oxyde de silicium et/ou ZrO₂.

7. Ensemble de chauffage par induction selon l'une quelconque des revendications précédentes, dans lequel les première et seconde couches de blindage électromagnétique (18, 20) diffèrent soit par leur conductivité électrique, soit par leur perméabilité magnétique, soit par les deux.

8. Ensemble de chauffage par induction selon l'une quelconque des revendications précédentes, dans lequel l'une des première ou seconde couches de blindage électromagnétique (18, 20) comprend un matériau ferrimagnétique, électriquement non-conducteur ; et l'autre des première ou seconde couches de blindage électromagnétique (18, 20) comprend un matériau électriquement conducteur.

9. Ensemble de chauffage par induction selon l'une quelconque des revendications précédentes, dans lequel la première couche de blindage électromagnétique (18) comprend un matériau ferrimagnétique, électriquement non-conducteur ; et la seconde couche de blindage électromagnétique (20) comprend un matériau électriquement conducteur.

10. Ensemble de chauffage par induction selon les revendications 8 ou 9, dans lequel le matériau ferrimagnétique, électriquement non-conducteur comprend de la ferrite, de la ferrite nickel-zinc ou du mu-métal ; et dans lequel le matériau électriquement conducteur comprend de l'aluminium, du graphite ou du cuivre.

11. Ensemble de chauffage par induction selon l'une quelconque des revendications précédentes, dans lequel la seconde couche de blindage électromagnétique (20) comprend un treillis.

12. Ensemble de chauffage par induction selon l'une quelconque des revendications précédentes, dans lequel les première et seconde couches de blindage électromagnétique (18, 20) sont espacées de manière sensiblement uniforme par une distance de 0,5 mm à 1,5 mm.

13. Ensemble de chauffage par induction selon l'une quelconque des revendications précédentes, dans lequel la structure (16) entoure sensiblement le compartiment tubulaire (14) de chauffage.

14. Ensemble de chauffage par induction selon l'une quelconque des revendications précédentes, dans lequel la structure (16) comprend une ou plusieurs couches supplémentaires de blindage électromagnétique (18, 20) et/ou une ou plusieurs couches supplémentaires d'isolation thermique (22, 24).

15. Dispositif (100) de génération d'aérosol comprenant un ensemble (10) de chauffage par induction selon l'une quelconque des revendications précédentes.
